# EUROPEAN PATENT APPLICATION

(11) **EP 4 462 617 A1**
(43) Date of publication of application: **13.11.2024**
(21) Application number: 22922861.4
(22) Date of filing: 29.01.2022
(51) Int. Cl.: H01S 5/042, H04B 10/50

(54) **CIRCUIT STRUCTURE, TRANSMITTING MODULE, DETECTION APPARATUS, AND TERMINAL DEVICE**

(71) Applicant: Huawei Technologies Co., Ltd., Shenzhen, Guangdong 518129 (CN)
(72) Inventor: ZHONG, Guowei, Shenzhen, Guangdong 518129 (CN); CAI, Zhonghua, Shenzhen, Guangdong 518129 (CN); GAO, Lei, Shenzhen, Guangdong 518129 (CN); QIAN, Zhenhai, Shenzhen, Guangdong 518129 (CN)
(74) Representative: Maiwald GmbH
(86) International application number: PCT/CN2022/074945
(87) International publication number: WO 2023/142030

(57) **Abstract**

A circuit structure, a transmit module, a detection apparatus, and a terminal device are provided, and are applicable to the field of electronic technologies. The circuit structure, the transmit module, the detection apparatus, and the terminal device may be used for autonomous driving or assisted driving. The circuit structure includes a switch component, a laser, and an energy storage element that are placed in a stacked manner, and may be applied to a lidar. The switch component is located at a first layer, and the laser and the energy storage element are located at a second layer. A first end of the switch component is connected to a first end of the laser through a first interlayer medium, a second end of the switch component is connected to a first end of the energy storage element through a second interlayer medium, and a second end of the laser is connected to a second end of the energy storage element. The switch component, the laser, and the energy storage element are stacked at different layers, so that a wire length of a loop formed by the switch component, the laser, and the energy storage element can be reduced, parasitic elements introduced due to a wire are further reduced, and effective energy conversion efficiency of the circuit structure is effectively improved.

## Description

### TECHNICAL FIELD

This application relates to the field of electronic technologies, and provides a circuit structure, a transmit module, a detection apparatus, and a terminal device.

### BACKGROUND

A lidar (light detection and ranging, LiDAR) is an optical measurement device. A working principle of the lidar is as follows: The lidar transmits a laser light signal to an object, receives a target echo signal obtained after the laser light signal is reflected by the object, and then compares the target echo signal with the laser light signal, to obtain related parameters such as a location and a distance of the object. The lidar can accurately scan surrounding objects to form high-definition images, thereby helping quickly identify and make decisions on the surrounding objects. Currently, the lidar has been widely used in scenarios such as an intelligent vehicle, smart transportation, city three-dimensional mapping, and atmospheric environment monitoring.

The lidar has a plurality of components. Currently, a layout of components on a printed circuit board (printed circuit board, PCB) introduces large additional parasitic elements. For example, a wire that is between components and that is on the PCB introduces an additional parasitic resistor, a parasitic inductor, and the like in a circuit. In addition, a longer wire indicates a larger introduced parasitic parameter value. In this way, in a working process of the lidar, more energy is consumed by the parasitic elements, and effective energy conversion efficiency used for working of a laser is reduced.

### SUMMARY

This application provides a circuit structure, a transmit module, a detection apparatus, and a terminal device, to reduce parasitic elements introduced in the circuit structure, and improve effective energy conversion efficiency of the circuit structure.

According to a first aspect, this application provides a circuit structure, including a switch component, a laser, and an energy storage element. The switch component, the laser, and the energy storage element are placed in a stacked manner. In addition, the switch component is located at a first layer, and the laser and the energy storage element are located at a second layer. A first end of the switch component is connected to a first end of the laser through a first interlayer medium, a second end of the switch component is connected to a first end of the energy storage element through a second interlayer medium, and a second end of the laser is connected to a second end of the energy storage element.

In the foregoing design, stacked placement refers to a layout manner in space. In this layout manner, an element may be laid out and designed in three-dimensional space, so that layout flexibility is improved, and a wire length between elements can be reduced, thereby reducing parasitic elements introduced due to a wire. Specifically, the switch component, the laser, and the energy storage element are stacked at different layers, so that a wire length between the switch component and the laser and a wire length between the switch component and the energy storage element can be reduced by laying out and designing the switch component and the laser, and the switch element and the energy storage element in the three-dimensional space. The laser and the energy storage element are placed at a same layer, so that a wire length between the laser and the energy storage element can be further reduced by placing the laser and a capacitor more compactly. It can be learned that the circuit structure can effectively reduce a wire length of a loop formed by the switch component, the laser, and the energy storage element, and further reduce parasitic elements introduced due to a wire, thereby helping improve effective energy conversion efficiency of the circuit structure.

It should be understood that locations of the first layer and the second layer are not limited in this application. For example, the first layer may be located above the second layer, or the first layer may be located below the second layer. In addition, the switch component placed at the first layer and one or two of the laser and the energy storage element that are placed at the second layer may entirely overlap, or may partially overlap. This is also not specifically limited in this application.

In a possible design, the energy storage element may be an element that can store electrical energy, for example, a capacitor or an inductor.

In a possible design, a first overlap may exist between projections of the switch component and the laser in a direction in which the switch component and the laser are placed in the stacked manner, and the first interlayer medium is disposed in an area corresponding to the first overlap between the first layer and the second layer. In this design, the first interlayer medium used to connect the switch component and the laser is disposed in the overlapping area, so that the wire length between the switch component and the laser depends on a spacing between a surface that is of the switch component and that is opposite to the laser and a surface that is of the laser and that is opposite to the switch component. In this way, the spacing may be set to be small enough, so that the wire length between the switch component and the laser is small enough.

In a possible design, a second overlap may exist between projections of the switch component and the energy storage element in a direction in which the switch component and the energy storage element are placed in the stacked manner, and the second interlayer medium is disposed in an area corresponding to the second overlap between the first layer and the second layer. In this design, the second interlayer medium used to connect the switch component and the energy storage element is disposed in the overlapping area, so that the wire length between the switch component and the energy storage element depends on a spacing between a surface that of the switch component and that is opposite to the energy storage element and a surface that is of the energy storage element and that is opposite to the switch component. In this way, the spacing may be set to be small enough, so that the wire length between the switch component and the energy storage element is small enough.

In a possible design, the circuit structure may further include a first PCB, and the first PCB is located between the first layer and the second layer. In this way, the first PCB can be configured to support a component located at an upper layer, and can further reduce electrical interference between the switch component and the laser and the energy storage element by separating the switch component located at the first layer from the laser and the energy storage element located at the second layer.

In a possible design, the first interlayer medium and the second interlayer medium pass through the first PCB. In this way, the switch component located at the first layer and the laser and the energy storage element that are located at the second layer are connected in a manner of passing through the first PCB, so that a winding connection can be avoided between the switch component and the laser and between the switch component and the energy storage element, and the wire length between the switch component and the laser and the wire length between the switch component and the energy storage element are effectively reduced.

In a possible design, the circuit structure may further include a second PCB. The laser and the energy storage element are disposed on the second PCB, and the second end of the laser is connected to the second end of the energy storage element through a wire on the second PCB. In this way, the second PCB may be used to carry the laser and the energy storage element.

In a possible design, a surface that is of the second PCB and that is opposite to the first PCB may be implemented by using a heat conducting material. The heat conducting material may include but is not limited to one or more of the following materials: copper, silver, aluminum alloy, graphene, graphite, carbon fiber, or the like. This helps improve heat dissipation effect of the laser and the energy storage element that are disposed on the second PCB in a working process.

In a possible design, the circuit structure may further include a driver chip. The driver chip is connected to a third end of the switch component. In this way, the driver chip may be configured to drive the switch component, so that the switch component is in a turned-on state or a turned-off state.

In a possible design, the driver chip may be located at the first layer. In this way, the driver chip and the switch component are placed at a same layer, so that the driver chip and the switch component can be easily connected, and a wire length between the driver chip and the switch component can be further reduced by laying out the driver chip and the switch component more compactly, thereby reducing parasitic elements introduced due to a wire between the driver chip and the switch component.

In a possible design, the driver chip and the switch component may be placed in a same package in a die form. A die refers to an unpackaged chip obtained after a wafer (namely, a circular silicon wafer used for manufacturing a silicon semiconductor integrated circuit) is cut and tested. An electrode of the die is directly exposed without being wrapped with a sheath. In this way, compared with a manner of separately packaging each component, a manner of packaging a die of the driver chip and a die of the switch component together (namely, a technology in which one package includes two or more dies) into one package can reduce a quantity of packages included in the circuit structure, thereby reducing parasitic elements introduced due to component packaging.

In a possible design, the driver chip and the switch component may be placed in different packages in the die form. In this way, the driver chip and the switch component are separately packaged, thereby helping reduce complexity of process production.

In a possible design, the circuit structure may further include a power supply. A positive electrode of the power supply is connected to the second end of the laser and the second end of the energy storage element, and a negative electrode of the power supply is grounded. In this way, the power supply may be used to supply power to the laser and the energy storage element.

In a possible design, the power supply may be disposed on the second PCB, and the positive electrode of the power supply is connected to the second end of the laser and the second end of the energy storage element through the wire on the second PCB. In this way, the power supply, and the laser and the energy storage element are placed at a same layer, so that the power supply and the laser can be easily connected, the power supply and the energy storage element can be easily connected, and the wire length between the power supply and the laser and the wire length between the power supply and the energy storage element can be reduced by laying out the power supply and the laser more compactly and laying out the power supply and the energy storage element more compactly, thereby reducing parasitic elements introduced due to a wire between the power supply and the laser and a wire between the power supply and the energy storage element.

In a possible design, the circuit structure may further include a conductive pillar. The conductive pillar is disposed on the second PCB and passes through the first PCB. The power supply is disposed on the first PCB, and the positive electrode of the power supply is connected to the second end of the laser and the second end of the energy storage element through a wire on the first PCB, the conductive pillar, and the wire on the second PCB. In this way, the power supply, and the laser and the energy storage element that are placed at different layers are connected through the conductive pillar, so that a winding connection can be avoided. In this way, even if the power supply, and the laser and the energy storage element are placed at different layers, parasitic elements introduced due to a wire between the power supply and the laser and a wire between the power supply and the energy storage element can be reduced.

In a possible design, the circuit structure may further include a resistor element. A first end of the resistor element is connected to the positive electrode of the power supply, and a second end of the resistor element is connected to the second end of the laser and the second end of the energy storage element. Alternatively, the first end of the resistor element is connected to the negative electrode of the power supply, and a second end of the resistor element is grounded after being connected to the second end of the switch component and the first end of the energy storage element. In this way, a current in the transmit module may be changed by using a resistor, to flexibly change a luminous intensity of the laser.

In a possible design, the laser may be a die. In this way, a quantity of packages in the circuit structure can be reduced, thereby reducing parasitic elements introduced due to component packaging.

In a possible design, the energy storage element may be a die. In this way, a quantity of packages in the circuit structure can be reduced, thereby reducing parasitic elements introduced due to component packaging.

According to a second aspect, this application provides a transmit module, including a power supply, a driver chip, and the circuit structure according to any design of the first aspect. The power supply is configured to supply power to the circuit structure, the driver chip is configured to send a drive signal to the circuit structure, and the circuit structure is configured to emit detection laser light based on the drive signal.

According to a third aspect, this application provides a detection apparatus, including a control circuit and the transmit module according to the second aspect. The control circuit is configured to send a control signal to the transmit module, and the transmit module is configured to emit detection laser light based on the control signal.

In a possible design, the detection apparatus may further include a receiving module. The receiving module is configured to: receive an echo signal returned after the detection laser light scans a target object, and convert the echo signal into an electrical signal. The control circuit is further configured to process the electrical signal, to obtain point cloud data.

In a possible design, the detection apparatus may further include a scanning module. The scanning module is configured to: traverse and scan the target object by using detection laser light.

In a possible design, the detection apparatus may be a lidar, or another apparatus that can emit detection laser light.

According to a fourth aspect, this application provides a terminal device, including the detection apparatus according to any design of the third aspect.

For specific beneficial effects of the second aspect to the fourth aspect, refer to technical effects that can be achieved in corresponding designs of the first aspect. Details are not described herein again.

### BRIEF DESCRIPTION OF DRAWINGS

FIG. 1 shows an example of a schematic diagram of an application scenario of a lidar according to an embodiment of this application;
FIG. 2 shows an example of a schematic diagram of an internal architecture of a lidar according to an embodiment of this application;
FIG. 3 shows an example of a schematic diagram of a component connection structure of a transmit module according to an embodiment of this application;
FIG. 4 shows an example of a schematic diagram of a layout manner of components in a transmit module;
FIG. 5 shows an example of a schematic diagram of a circuit structure according to an embodiment of this application;
FIG. 6 shows an example of a schematic diagram of another circuit structure according to an embodiment of this application;
FIG. 7 shows an example of a schematic diagram of a structure of a die according to an embodiment of this application;
FIG. 8 shows an example of a schematic diagram of still another circuit structure according to an embodiment of this application;
FIG. 9 shows an example of a schematic diagram of yet another circuit structure according to an embodiment of this application;
FIG. 10 shows an example of a schematic diagram of still another circuit structure according to an embodiment of this application;
FIG. 11 shows an example of a schematic diagram of yet another circuit structure according to an embodiment of this application;
FIG. 12 shows an example of a schematic diagram of still another circuit structure according to an embodiment of this application; and
FIG. 13 shows an example of a schematic diagram of yet another circuit structure according to an embodiment of this application.

### DESCRIPTION OF EMBODIMENTS

The following clearly and completely describes the technical solutions in embodiments of this application with reference to the accompanying drawings in embodiments of this application.

It should be noted that a "connection" in the following embodiments of this application may be an electrical connection, and a connection between two electrical elements may be a direct or indirect connection between the two electrical elements. For example, a connection between A and B may represent that A and B are directly connected to each other, or A and B are indirectly connected to each other through one or more other electrical elements. For example, the connection between A and B may also represent that A is directly connected to C, C is directly connected to B, and A and B are connected to each other through C. In some scenarios, the "connection" may alternatively be understood as coupling, for example, electromagnetic coupling between two inductors. In a word, A and B are connected, so that electrical energy can be transmitted between A and B.

In addition, end names of electronic components in the following embodiments of this application are merely examples for description. Ends of the electronic components may be understood as connection ends or connection points, and are configured to connect to other circuit components. In other examples, there may be other end names, connection end names, or connection point names. For example, in some scenarios, an end may alternatively be referred to as a communication end, an information transmission end, a terminal, a connection end, a communication connection end, an information connection end, a connection point, a communication connection point, an information connection point, an electrode, or the like.

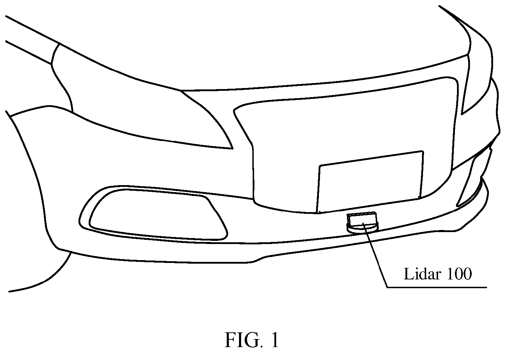

An embodiment of this application provides a circuit structure. The circuit structure may be applied to a detection apparatus, for example, a lidar, in an application scenario. FIG. 1 shows an example of a schematic diagram of an application scenario of a lidar according to an embodiment of this application. In this example, a lidar 100 is mounted on a vehicle, and therefore, is also referred to as a vehicle-mounted lidar. In addition to the vehicle-mounted lidar, the lidar further includes a ship-mounted lidar installed on a ship, a machine-mounted lidar installed on a machine, or the like. In a possible example, as shown in FIG. 1, the lidar 100 may be installed, for example, at a head position of a vehicle. In this way, in a driving process of the vehicle, the lidar 100 may emit a laser light signal. After being irradiated to an object in a surrounding environment, the laser light signal is reflected by the object, and a target echo signal reflected back by the object may be received by the lidar 100. Then, the lidar 100 detects environment information around the vehicle based on the target echo signal, to assist or control a driving function of the vehicle based on the environment information. For example, the driving function includes, but is not limited to, autonomous driving or assisted driving.

It should be noted that the lidar 100 may be one of a mechanical lidar, a liquid-state lidar, a pure solid-state lidar, or a hybrid solid-state lidar (also referred to as a semi-solid-state lidar), or may be another type of lidar. This is not specifically limited in embodiments of this application. In addition, a housing of the lidar 100 may be a cuboid shown in FIG. 1, or may be a square, a cylinder, a ring, an odd form, or the like. A shape of the housing of the detection apparatus is also not specifically limited in embodiments of this application.

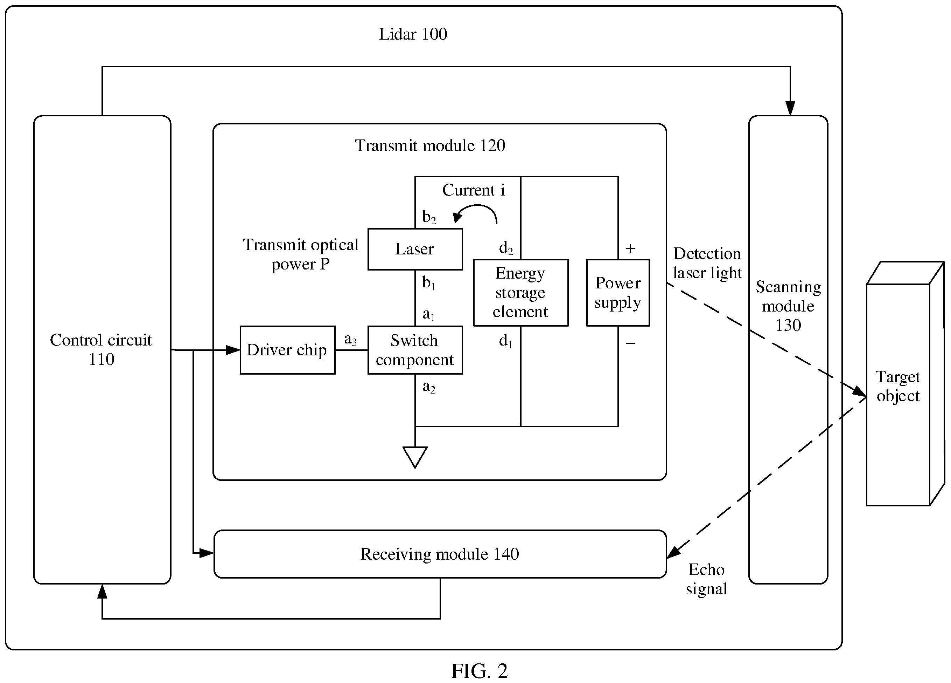

Further, for example, FIG. 2 is a schematic diagram of an internal architecture of a lidar according to an embodiment of this application. As shown in FIG. 2, the lidar 100 may include a control circuit 110, a transmit module 120, a scanning module 130, and a receiving module 140. The transmit module 120 and the receiving module 140 include optical elements, such as one or more of a lens, a light filter, a polarizer, a reflector, a beam splitter, a prism, a window plate, and a scattering plate. A specific quantity of included optical elements and specific types of included optical elements are related to optical designs of the transmit module 120 and the receiving module 140 in the lidar 100. This is not specifically limited in embodiments of this application. The transmit module 120 may include at least one laser. The at least one laser may be connected in series or in parallel, and is configured to emit detection laser light under control of the control circuit 110. The scanning module 130 may include one or more of a multifaceted rotating mirror, a pendulum mirror, a micro-electro-mechanical system (micro-electro-mechanical system, MEMS) scanning mirror, and a prism. The scanning module 130 is configured to change, under control of the control circuit 110, a scanning angle of the detection laser light emitted by the transmit module 120, so that the detection laser light can scan and traverse a target object in an environment. In different types of lidars, implementations of the scanning module 130 are different. In addition, there is no scanning module in some types of lidars, for example, a phased array radar in a solid-state lidar. In addition, the detection laser light is further reflected by the target object in the environment, to generate an echo signal. The receiving module 140 is configured to: receive, under control of the control circuit 110, the echo signal corresponding to the detection laser light; convert the echo signal into an electrical signal; and send the electrical signal to the control circuit 110. The control circuit 110 determines a feature of the target object based on the electrical signal. It should be noted that the lidar 100 may alternatively include more or fewer components than those shown in FIG. 2. This is not specifically limited in embodiments of this application.

The control circuit 110 may include at least one integrated circuit chip. For example, the control circuit 110 may include at least one processor, and when the control circuit 110 includes a plurality of processors, types of the included processors may be the same or different. The processor is an element or a circuit that has a processing capability. For example, the processor includes one or more of the following types: a general-purpose processor, a field programmable gate array (field programmable gate array, FPGA), an application-specific integrated chip (application-specific integrated circuit, ASIC), a neural-network processing unit (neural-network processing unit, NPU), a graphics processing unit (graphics processing unit, GPU), an application processor (application processor, AP), a modem processor, an image signal processor (image signal processor, ISP), a video codec, a digital signal processor (digital signal processor, DSP), a baseband processor, a network processor (network processor, NP), a digital signal processor (digital signal processor, DSP), a micro controller unit (micro controller unit, MCU), a programmable controller (programmable logic device, PLD), or another programmable logic device, a discrete gate or transistor logic device, a discrete hardware component, or another integrated chip. The general-purpose processor includes, for example, a central processing unit (central processor unit, CPU). In addition, all or some integrated circuit chips included in the control circuit 110 may be integrated together and presented in a form of a system on chip (system on chip, SoC).

In an optional implementation, still as shown in FIG. 2, the transmit module 120 may include a driver chip, a switch component, a laser, an energy storage element, and a power supply. An input end of the driver chip is connected to the control circuit 110, and an output end of the driver chip is connected to a third end (a₃) of the switch component. A first end (a₁) of the switch component is connected to a first end (bi) of the laser. A second end (b₂) of the laser is separately connected to a second end (d₂) of the energy storage element and a positive electrode of the power supply. A second end (a₂) of the switch component is grounded after being separately connected to a first end (di) of the energy storage element and a negative electrode of the power supply (namely, a component marked with an inverted triangle "V" in FIG. 2; grounding means that the component may be connected to the ground through a conductor, or means that a grounding circuit may be disposed, and the component is connected to the grounding circuit; and this is not specifically limited). The driver chip may be a chip that can drive the switch component to be turned on or turned off, and may be generally implemented by integrating a plurality of levels of driver components into one electronic chip. The switch component may be any component that can implement turning-on and turning-off, for example, a field-effect transistor (field-effect transistor, FET). The FET may be an N-channel metal-oxide-semiconductor field-effect transistor (N-channel metal-oxide-semiconductor field-effect transistor, NMOSFET), or may be a P-channel metal-oxide-semiconductor field-effect transistor (P-channel metal-oxide-semiconductor field-effect transistor, PMOSFET). This is not specifically limited. The laser may be a single laser, or may be a laser chain including a plurality of lasers that are connected in series, or may be a laser ring including a plurality of lasers that are connected in parallel, or may be a laser array including a plurality of lasers that are connected in series and in parallel. A type of the laser may be an edge emitting laser (edge emitting laser, EEL), or may be a surface emitting laser (surface emitting laser, SEL). This is not specifically limited. The energy storage element may be an element that can store electrical energy, for example, a capacitor (like a silicon capacitor) or an inductor.

In the foregoing implementation, in a process of controlling the transmit module 120 to work, the control circuit 110 may send a periodically repeated pulse control signal. For example, the control circuit 110 emits, in a time period previous to a period, a first control signal used to turn off the switch component, and emits, in a time period next to the period, a second control signal used to turn on the switch component. In this way, in the time period previous to the period, the driver chip drives, based on the first control signal, the first end a₁ and the second end a₂ of the switch component to be disconnected. In this case, electrical energy output by the power supply is provided to the energy storage element but is not provided to the laser. Therefore, the energy storage element may store the electrical energy output by the power supply. Then, in the time period next to the period, the driver chip drives, based on the second control signal, the first end a₁ and the second end a₂ of the switch component to be connected. In this case, the energy storage element that has stored the energy in the previous period starts to discharge, and the discharge enables a transient current i to be formed in a loop formed by the laser, the switch component, and the energy storage element. The transient current i drives the laser to emit detection laser light. In addition, a larger value of the transient current i indicates a larger transmit optical power P of the laser. In this way, based on the periodically repeated pulse control signal of the control circuit 110, the laser in the transmit module 120 correspondingly emits light periodically.

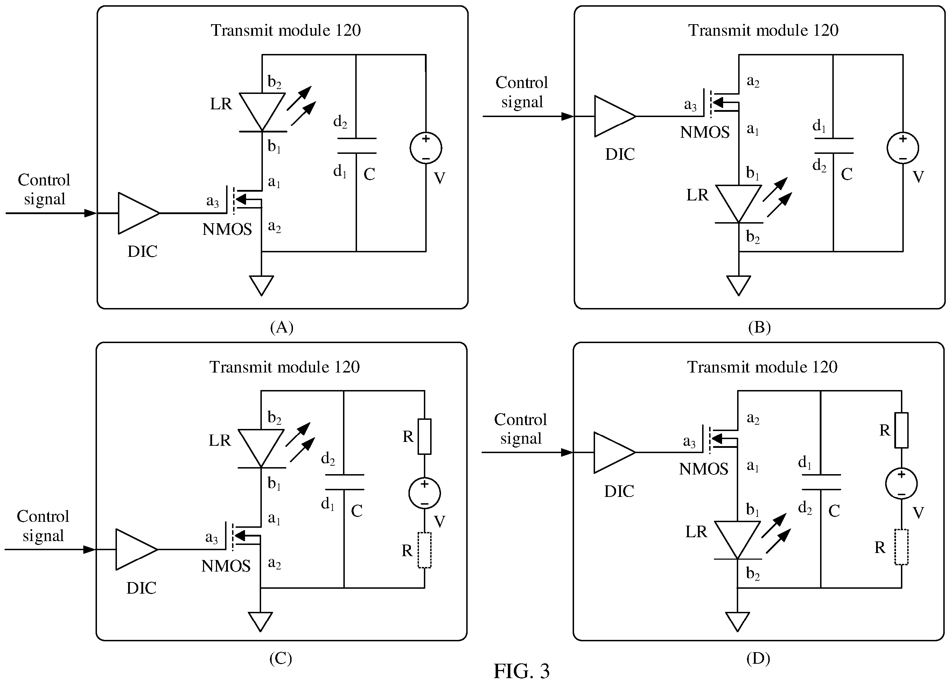

Further, in this embodiment of this application, there are a plurality of possible connection manners of the components in the transmit module 120. For example, it is assumed that the switch component is an NMOS transistor, the driver chip is a driver integrated circuit chip (driver integrated circuit chip, DIC), the laser is a single laser (laser, LR), and the energy storage element is a capacitor C. In this case, FIG. 3 shows an example of a schematic diagram of a component connection structure of a transmit module according to an embodiment of this application.

In an example, as shown in (A) in FIG. 3, the first end a₁ of the switch component is a drain of the NMOS transistor, the second end a₂ of the switch component is a source of the NMOS transistor, the third end as of the switch component is a gate of the NMOS transistor, the first end b₁ of the laser is a cathode of the laser LR, and the second end b₂ of the laser is an anode of the laser LR. A specific connection manner is as follows: An output end of the driver chip DIC is connected to the gate as of the NMOS transistor, the drain a₁ of the NMOS transistor is connected to the cathode b₁ of the laser LR, the anode b₂ of the laser LR is separately connected to the second end d₂ of the capacitor C and the positive electrode of the power supply, and the source a₂ of the NMOS transistor is grounded after being separately connected to the first end d₁ of the capacitor C and the negative electrode of the power supply. According to the circuit connection structure, in a process of controlling the transmit module 120 to work, the control circuit 110 may output a low-level first control signal to the driver chip DIC in a time period previous to a period, and output a high-level second control signal to the driver chip DIC in a time period next to the period. In this way, in the time period previous to the period, the driver chip DIC drives, based on a low level, the source a₂ and the drain a₁ of the NMOSFET to be disconnected. In this case, electrical energy output by a power supply V cannot be provided to the laser LR, but can be provided to the capacitor C, to charge the capacitor C. In this case, because a link on which the laser LR is located is disconnected, the laser LR does not emit detection laser light. Then, in the time period next to the period, the driver chip DIC drives, based on a high level, the source a₂ and the drain a₁ of the NMOSFET to be connected. In this case, the link on which the laser LR is located is turned on, and the capacitor C may discharge to the laser LR. Therefore, the laser LR may emit detection laser light.

In another example, as shown in (B) in FIG. 3, the first end a₁ of the switch component is the source of the NMOS transistor, the second end a₂ of the switch component is the drain of the NMOS transistor, the third end as of the switch component is the gate of the NMOS transistor, the first end b₁ of the laser is the anode of the laser LR, and the second end b₂ of the laser is a cathode of the laser LR. A specific connection manner is as follows: The output end of the driver chip DIC is connected to the gate as of the NMOS transistor, the source a₁ of the NMOS transistor is connected to the cathode b₁ of the laser LR, the anode b₂ of the laser LR is grounded after being separately connected to the second end d₂ of the capacitor C and the negative electrode of the power supply, and the drain a₂ of the NMOS transistor is separately connected to the first end d₁ of the capacitor C and the positive electrode of the power supply. It should be noted that a working process of the circuit connection structure shown in (B) in FIG. 3 is similar to that of the circuit connection structure shown in (A) in FIG. 3. A reason lies on the following: The capacitor C actually includes two mutually insulated conductors approaching each other. In the circuit connection structure shown in (A) in FIG. 3, when the capacitor C is charged in the previous time period, a conductor that forms the second end d₂ of the capacitor C has positive electricity, and a conductor that forms the first end d₁ of the capacitor C has negative electricity. Therefore, when the capacitor C discharges in the next period, electrical energy output by the conductor that forms the second end d₂ of the capacitor C sequentially flows through the anode b₂ of the laser LR, the cathode b₁ of the laser LR, the drain a₁ of the NMOS transistor, and the source a₂ of the NMOS transistor, and then flows back to the conductor that forms the first end d₁ of the capacitor C, to drive the laser LR to emit light. Similarly, in the circuit connection structure shown in (B) in FIG. 3, when the capacitor C is charged in the previous time period, a conductor that forms the first end d₁ of the capacitor C has positive electricity, and a conductor that forms the second end d₂ of the capacitor C has negative electricity. Therefore, when the capacitor C discharges in the next period, electrical energy output by the conductor that forms the first end d₁ of the capacitor C sequentially flows through the drain a₂ of the NMOS transistor, the source a₁ of the NMOS transistor, the anode b₁ of the laser LR, and the cathode b₂ of the laser LR, and then flows back to the conductor that forms the second end d₂ of the capacitor C, to drive the laser LR to emit light.

It should be noted that the foregoing content merely describes two possible component connection manners in the transmit module as examples. In an actual operation, some variations may be further made to the foregoing shown connection manners. These variations fall within the protection scope of embodiments of this application, provided that a transmit function of the transmit module is not affected. This is not specifically limited in embodiments of this application.

In addition, the components included in the transmit module may be further deformed. For example, some components in the transmit module are modified to other components that can implement a same function. For example, the NMOS transistor is replaced with a diode or a PMOS transistor. When the NMOS transistor is replaced with the PMOS transistor, the PMOS transistor is turned on at a low level and tuned off at a high level. Therefore, if the control circuit still emits the low-level first control signal in a time period previous to a period, and emits the high-level second control signal in a time period next to the period, the laser emits detection laser light in the time period previous to the period, and does not emit detection laser light in the time period next to the period. For another example, some components may be further added to or removed from the transmit module. For example, in a possible variant, as shown in (C) in FIG. 3 or (D) in FIG. 3, the transmit module 120 may further include a resistor element R, and the resistor element R is connected in series to the power supply V. For example, in an example, as shown in (C) in FIG. 3, a first end of the resistor element R is connected to a positive electrode of the power supply V, and a second end of the resistor element R is connected to the anode b₂ of the laser LR and the second end d₂ of the capacitor C; or a first end of the resistor element R is connected to a negative electrode of the power supply V, and a second end of the resistor element R is grounded after being connected to the source a₂ of the NMOS transistor and the first end d₁ of the capacitor C. Alternatively, in another example, as shown in (D) in FIG. 3, a first end of the resistor element R is connected to a positive electrode of the power supply V, and a second end of the resistor element R is connected to the drain a₂ of the NMOS transistor and the first end d₁ of the capacitor C; or a first end of the resistor element R is connected to a negative electrode of the power supply V, and a second end of the resistor element R is grounded after being connected to the cathode b₂ of the laser LR and the second end d₂ of the capacitor C. For a working process of the circuit connection structure, refer to the circuit connection structure shown in (A) in FIG. 3 or (B) in FIG. 3. A difference lies in the following. In a time period previous to a period, a part of electrical energy output by the power supply V is consumed by a resistor R, and the other part is provided for the capacitor C. In other words, after charging is completed, electrical energy stored in the capacitor C is less than that in the structure shown in (A) in FIG. 3 or (B) in FIG. 3. In a time period next to the period, the capacitor C, the resistor R, and the laser LR form a loop. Therefore, a current on the loop is lower than that on the loop that is shown in (A) in FIG. 3 or (B) in FIG. 3 and that includes only the capacitor C and the laser LR, and accordingly, intensity of detection laser light emitted by the laser LR is weaker than that of the structure shown in (A) in FIG. 3 or (B) in FIG. 3. In addition, if the intensity of the detection laser light needs to be flexibly adjusted, the resistor R may be further set as a variable resistor. When detection laser light having weak intensity needs to be emitted, a resistance value of the variable resistor is set to a larger value. When detection laser light having strong intensity needs to be emitted, a resistance value of the variable resistor is set to a smaller value.

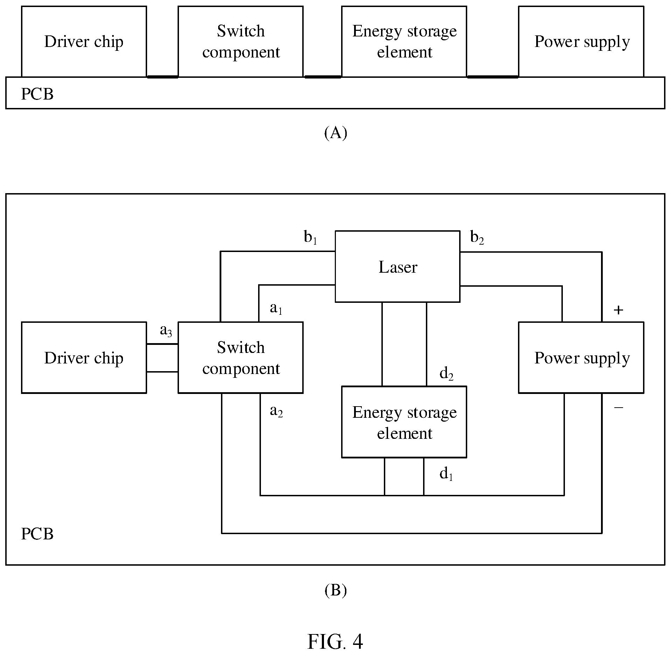

Further, based on the transmit module 120 shown in FIG. 2, FIG. 4 shows an example of a schematic diagram of a layout manner of components in a transmit module. (A) in FIG. 4 shows a main view of the layout manner of the components in the transmit module, and (B) in FIG. 4 shows a top view of the layout manner of the components in the transmit module. As shown in (A) in FIG. 4 and (B) in FIG. 4, a PCB board is disposed in this layout manner. After the driver chip, the switch component, the laser, the energy storage element, and the power supply in the transmit module 120 are all separately packaged into a package, the driver chip, the switch component, the laser, the energy storage element, and the power supply in the transmit module 120 are laid out on the PCB board in a plane manner. In addition, the packages are connected through a wire on the PCB. In a partial circuit structure, parasitic elements (for example, a parasitic resistor and a parasitic inductor) are introduced into the circuit structure due to a quantity of packages included in the circuit structure and a wire. In addition, the introduced parasitic elements are connected in series on a link on which the laser is located. It is assumed that the parasitic resistor is R, the parasitic inductor is L, an output power of the power supply is Pₒᵤₜ, and optical-electro conversion efficiency is η. It can be learned from the working principle of the transmit module described in FIG. 2 that the transient current i is formed because the energy storage element discharges after the switch component is started. As the parasitic inductor L and the parasitic resistor R that are connected in series on the link on which the laser is located decrease, the transient current i increases correspondingly, so that the transmit optical power P of the laser also increases. In other words, the transmit optical power P of the laser is approximately proportional to the transient current i, and the transient current i is approximately proportional to 1/LR. Therefore, the transmit optical power P of the laser may be understood as being approximately proportional to 1/LR. In this way, under the same output power Pₒᵤₜ of the power supply, the electro-optical conversion efficiency η may be defined as a ratio of the transmit optical power P of the laser to the output power Pₒᵤₜ of the power supply, that is, η=P/Pout. Because P is approximately proportional to 1/LR, the electro-optical conversion efficiency η may be approximately proportional to 1/LR. In conclusion, the parasitic inductor L and the parasitic resistor R are reduced, so that the electro-optical conversion efficiency η in the transmit module can be improved.

However, when the circuit structure includes a larger quantity of packages and a longer wire length, parameter values of the parasitic inductor and the parasitic resistor introduced in the circuit structure are larger. In the foregoing layout manner, separately packaging each component causes a large quantity of packages in the transmit module, and a plane layout between the packages causes winding of wires on the PCB board. Both the large quantity of packages and the winding of wires introduce a large parasitic inductor and a large parasitic resistor to the transmit module, thereby reducing a transmit optical power of the laser when the laser emits detection laser light. It can be learned that, in the foregoing layout manner, efficiency of converting electrical energy into optical energy by the transmit module is reduced. This is not conducive to improving electro-optical conversion efficiency of the transmit module.

In view of this, embodiments of this application provide a circuit structure, to reduce parasitic elements introduced in the circuit structure, and improve effective energy conversion efficiency of the circuit structure. For example, when the circuit structure is a transmit module, parasitic elements introduced in the transmit module are reduced, to improve electro-optical conversion efficiency of the transmitter module.

The following describes, by using specific embodiments, specific implementation of the circuit structure provided in embodiments of this application.

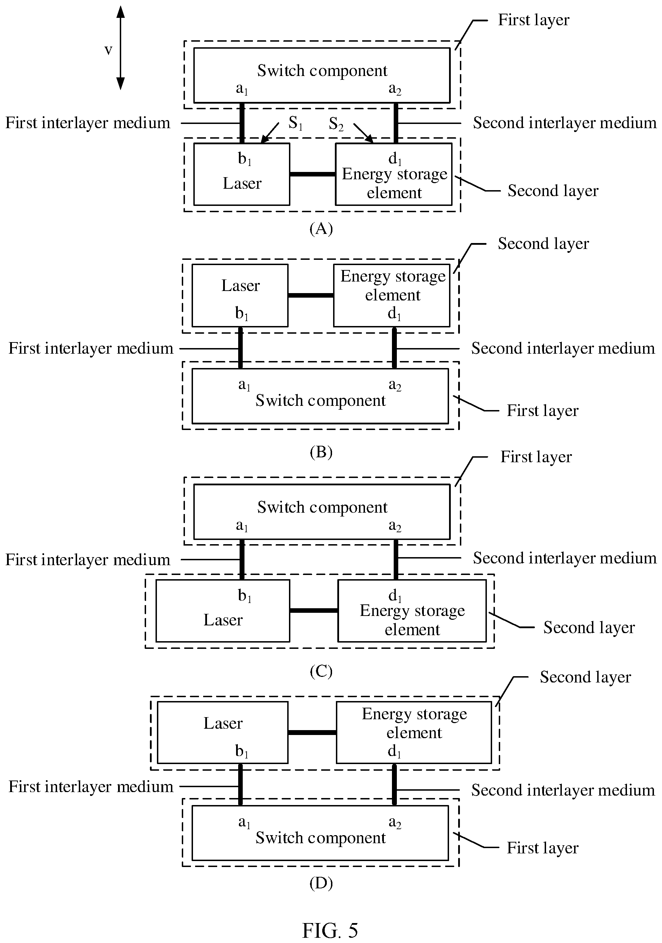

FIG. 5 shows an example of a schematic diagram of a circuit structure according to an embodiment of this application. As shown in FIG. 5, the circuit structure includes a switch component, a laser, and an energy storage element. The switch component, the laser, and the energy storage element are placed in a stacked manner. In addition, the switch component is located at a first layer, and the laser and the energy storage element are located at a second layer. A first end a₁ of the switch component is connected to a first end b₁ of the laser through a first interlayer medium, a second end a₂ of the switch component is connected to a first end d₁ of the energy storage element through a second interlayer medium, and a second end b₂ of the laser is connected to a second end d₂ of the energy storage element. The interlayer medium is a medium used to implement, between two layers, a connection between components at the two layers. The medium may be a conducting wire, or may be a conductor, or may be another medium material that can implement a conductive function. This is not specifically limited. In this way, the switch component, the laser, and the energy storage element are stacked at different layers, so that a wire length between the switch component and the laser and a wire length between the switch component and the energy storage element can be reduced in a three-dimensional layout manner. The laser and the energy storage element are placed at a same layer, so that a wire length between the laser and the energy storage element can be further reduced by placing the laser and a capacitor more compactly. It can be learned that, compared with the circuit structure in the plane layout manner shown in FIG. 4, the circuit structure can effectively reduce, through a three-dimensional layout, a wire length of a loop formed by the switch component, the laser, and the energy storage element, and further reduce parasitic elements introduced due to a wire, thereby helping improve effective energy conversion efficiency of the circuit structure.

In this embodiment of this application, there may be a plurality of possible location relationships between the first layer and the second layer. For example, the first layer may be located above the second layer as shown in (A) in FIG. 5 or (C) in FIG. 5, or may be located below the second layer as shown in (B) in FIG. 5 or (D) in FIG. 5. This is not specifically limited in embodiments of this application.

In this embodiment of this application, stacked placement refers to a layout manner in space. In this layout manner, an element may be laid out and designed in three-dimensional space, so that layout flexibility is improved, and a wire length between elements can be reduced, thereby reducing parasitic elements introduced due to a wire. Further, the elements are placed in a stacked manner, and a projection in a stacked placement direction (for example, a vertical direction) includes an overlapping part (entirely overlapping or partially overlapping). In this case, an interlayer medium may be disposed between surfaces of elements corresponding to the overlapping part, so that the elements are connected through the interlayer medium, thereby further reducing the wire length. FIG. 5 is used as an example. The switch component is placed at the first layer, and the laser and the energy storage element are placed at the second layer. In the stacked placement direction (namely, a direction v shown in FIG. 5), a projection of the switch component and a projection of the laser have an overlapping part, and the overlapping part corresponds to a surface Si of the laser. The projection of the switch component and a projection of the energy storage element have an overlapping part, and the overlapping part corresponds to a surface S₂ of the energy storage element. An interlayer medium is disposed between a surface that is of the switch component and that is opposite to the laser and the surface S₁ of the laser, and an interlayer medium is disposed between a surface that is of the switch component and that is opposite to the energy storage element and the surface S₂ of the energy storage element, to implement an interlayer connection and reduce a wire length. For example, as shown in (A) in FIG. 5 or (B) in FIG. 5, the projections that are of the laser and the energy storage element and that are in the direction v entirely overlap the projection of the switch component. Alternatively, as shown in (C) in FIG. 5 or (D) in FIG. 5, the projections that are of the laser and the energy storage element and that are in the direction v partially overlap the projection of the switch component. Alternatively, as shown in (A) in FIG. 5 or (B) in FIG. 5, the projection that is of the laser and that is in the direction v entirely overlaps the projection of the switch component, and as shown in (C) in FIG. 5 or (D) in FIG. 5, the projection of the energy storage element in the direction v partially overlaps the projection of the switch component. Alternatively, as shown in (A) in FIG. 5 or (B) in FIG. 5, the projection that is of the energy storage element and that is in the direction v entirely overlaps the projection of the switch component, and as shown in (C) in FIG. 5 or (D) in FIG. 5, the projection that is of the laser and that is in the direction v partially overlaps the projection of the switch component, or the like. This is also not specifically limited in embodiments of this application.

In an example, still refer to FIG. 5. There may be a first overlap between projections of the switch element and the laser in the stacked placement direction v, and the first interlayer medium is disposed in an area corresponding to the first overlap between the first layer and the second layer. For example, the first interlayer medium connects the switch component to the laser in a straight line manner in the area corresponding to the first overlap. In this way, the wire length between the switch component and the laser depends on a spacing between a surface that is of the switch component and that is opposite to the laser and a surface that is of the laser and that is opposite to the switch component. The spacing may be set to be small enough, so that the wire length between the switch component and the laser is also small enough.

In an example, still refer to FIG. 5. There may be a second overlap between projections of the switch element and the energy storage element in the stacked placement direction v, and the second interlayer medium is disposed in an area corresponding to the second overlap between the first layer and the second layer. For example, the second interlayer medium connects the switch component to the energy storage element in a straight line manner in the area corresponding to the second overlap. In this way, the wire length between the switch component and the energy storage element depends on a spacing between a surface that of the switch component and that is opposite to the energy storage element and a surface that is of the energy storage element and that is opposite to the switch component. The spacing may be set to be small enough, so that the wire length between the switch component and the energy storage element is also small enough.

For example, the following further describes several possible specific layout solutions of the components in the circuit structure by using the layout manner shown in (C) in FIG. 5 as an example.

### Layout solution 1

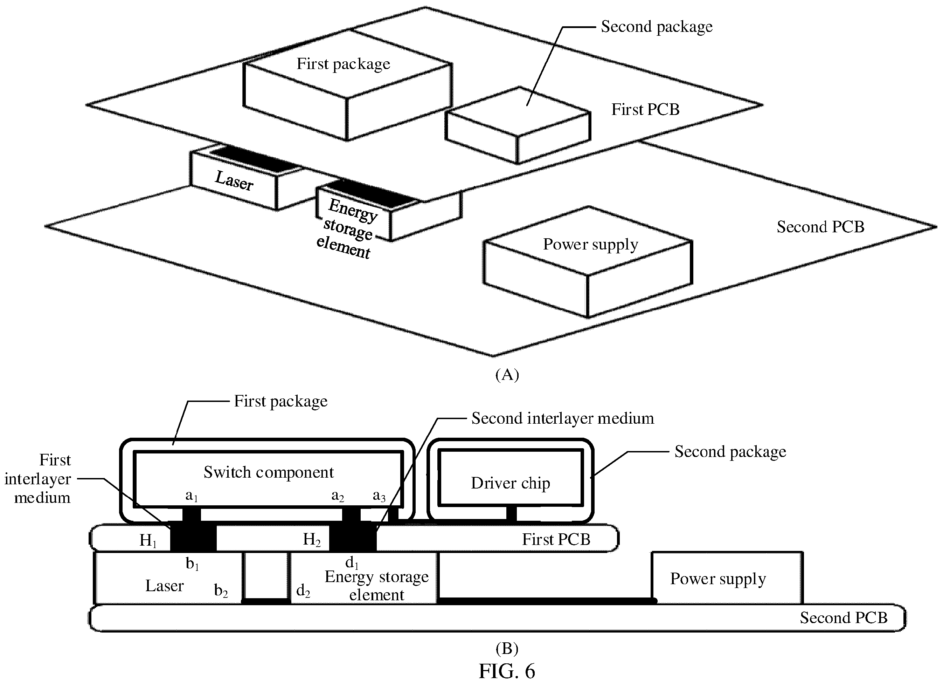

FIG. 6 shows an example of a schematic diagram of another circuit structure according to an embodiment of this application. (A) in FIG. 6 shows a spatial view of the circuit structure, and (B) in FIG. 6 shows a planar view of the circuit structure. As shown in (A) in FIG. 6 and (B) in FIG. 6, in this example, in addition to the switch component located at the first layer and the laser and the energy storage element located at the second layer, the circuit structure may further include a first PCB. The first PCB is located between the first layer and the second layer, and is configured to carry the switch component placed at the first layer. In addition, the first PCB can further separate the switch component located at the first layer from the laser and the energy storage element located at the first layer, to reduce electrical interference to the components at the two layers in a working process.

Further, for example, still refer to (B) in FIG. 6. The first interlayer medium and the second interlayer medium may pass through the first PCB. Specifically, a first through hole H1 is provided in an area that is of the first PCB and that corresponds to the first overlap, and a second through hole H2 is provided in an area that is of the first PCB and that corresponds to the second overlap. The first through hole H1 and the second through hole H2 are filled with a conductive medium. The first end a₁ of the switch component is in contact with an upper surface of the conductive medium that fills the first through hole H1, and the first end b₁ of the laser is in contact with a lower surface of the conductive medium that fills the first through hole H1, to implement a connection between the first end a₁ of the switch component and the first end b₁ of the laser. The second end a₂ of the switch component is in contact with an upper surface of the conductive medium that fills the second through hole H2, and the first end d₁ of the energy storage element is in contact with a lower surface of the conductive medium that fills the second through hole H2, to implement a connection between the second end a₂ of the switch component and the first end d₁ of the energy storage element. In this way, the switch component located at the first layer and the laser and the energy storage element that are located at the second layer are connected in a manner of passing through the first PCB, so that a winding connection can be avoided between the switch component and the laser and between the switch component and the energy storage element, and the wire length between the switch component and the laser and the wire length between the switch component and the energy storage element are effectively reduced.

In the foregoing example, the conductive medium may be a single medium or a hybrid medium having a conductive capability, for example, a metal, an alloy (for example, a copper alloy or an aluminum alloy), a composite metal, a conductive plastic, a conductive rubber, a conductive fiber fabric, a conductive coating, a conductive adhesive, or a transparent conductive thin film and a hybrid material thereof. This is not specifically limited. In addition, cross-sectional shapes of the first through hole H1 and the second through hole H2 may be set by a person skilled in the art based on experience. For example, the cross-sectional shape may be a circle, a square, a rectangle, an ellipse, a polygon, a special shape, or another shape. This is also not specifically limited.

Further, for example, still refer to (B) in FIG. 6. The circuit structure may further include a second PCB. The laser and the energy storage element are disposed on the second PCB, and the second end b₂ of the laser is connected to the second end d₂ of the energy storage element through a wire on the second PCB. In this example, the second PCB may be configured to carry the laser and the energy storage element. In addition, the first PCB and the second PCB are laid out in the manner shown in (B) in FIG. 6, so that the energy storage element of the laser can be further sandwiched between the first PCB and the second PCB, thereby forming a sandwich architecture. This further improves stability of the laser and the energy storage element in the circuit structure.

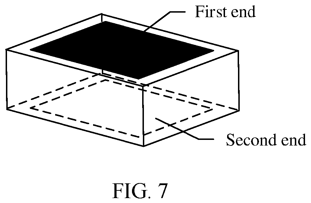

In the foregoing example, the laser may be a die of the laser, and the energy storage element may also be a die of the energy storage element. The die refers to an unpackaged chip obtained after a wafer (namely, a circular silicon wafer used for manufacturing a silicon semiconductor integrated circuit) is cut and tested. For example, FIG. 7 shows an example of a schematic diagram of a structure of a die. As shown in FIG. 7, electrodes of the die are usually directly exposed. For example, a first end of the die is exposed on an upper side surface of the die, and a second end of the die is exposed on a lower side surface of the die, as shown in the figure. In this way, an upper side surface of the die of the laser shown in (A) in FIG. 6 may include the first end b₁ of the laser, and a lower side surface shown in (A) in FIG. 6 may include the second end b₂ of the laser. When the die of the laser is disposed on the second PCB, the lower side surface corresponding to the second end b₂ of the laser may be disposed on an upper surface of the second PCB in a manner of silver paste bonding, gold tin soldering, or the like; and the upper side surface corresponding to the first end b₁ of the laser may be in contact with the lower surface of the conductive medium that fills the first through hole H1, to implement a connection between the first end b₁ of the laser and the first end a₁ of the switch component. Correspondingly, an upper side surface of the die of the energy storage element shown in (A) in FIG. 6 may include a first end d₁ of the energy storage element, and a lower side surface shown in (A) in FIG. 6 may include a second end d₂ of the energy storage element. When the die of the energy storage element is disposed on the second PCB, the lower surface corresponding to the second end d₂ of the energy storage element may be disposed on the upper surface of the second PCB in a manner of silver paste bonding, gold tin soldering, or the like; and the upper surface corresponding to the first end d₁ of the energy storage element may be in contact with the lower surface of the conductive medium that fills the second through hole H2, to implement a connect between the first end d1₁ of the energy storage element and the second end a₂ of the switch component. In this way, the die of the laser and the die of the energy storage element are directly laid out in the circuit structure, so that a quantity of packages included in the circuit structure can be reduced, thereby helping reduce parasitic elements introduced due to component packaging.

In another example, it is considered that a die layout process is difficult, and therefore, the laser and/or the energy storage element may be first packaged and then disposed on the second PCB, to reduce process manufacturing complexity. For example, the laser and the energy storage element are separately packaged into two packages and then separately disposed on the second PCB. Alternatively, the laser and the energy storage element are first packaged into one package, and then the package is disposed on the second PCB. This is not specifically limited in embodiments of this application.

In the foregoing example, a surface that is of the second PCB and that is opposite to the laser and the energy storage element may be implemented by using a heat conducting material. The heat conducting material may include but is not limited to one or more of the following materials: copper, silver, aluminum alloy, graphene, graphite, carbon fiber, or the like. In this way, heat generated by the laser and the energy storage element that are disposed on the second PCB in a working process can be further timely dissipated by a surface of the second PCB, so that a risk of damage to the laser and the energy storage element due to overheat can be reduced, thereby helping maintain life of the laser and the energy storage element.

Further, for example, still refer to (B) in FIG. 6. The circuit structure may further include a driver chip, and the driver chip is connected to the third end as of the switch component. The driver chip is configured to send a drive signal to the third end as of the switch component, to drive the first end a₁ and the second end a₂ of the switch component to be turned on or turned off.

In the foregoing example, the driver chip may be located at the first layer, that is, the driver chip and the switch component are located at a same layer. In this way, the driver chip and the switch component can be easily connected, and a wire length between the driver chip and the switch component can be further reduced by laying out the driver chip and the switch component more compactly, thereby reducing parasitic elements introduced due to a wire between the driver chip and the switch component.

In the foregoing example, there are a plurality of possible layout manners of the driver chip and the switch component that are located at the first layer. Examples are as follows.

In an example, still refer to (B) in FIG. 6. The driver chip and the switch component may be separately packaged in different packages. A packaging manner may include but is not limited to quad flat no-leads package (quad flat no-leads package, QFN), a chip scale package (chip scale package, CSP), or the like. Specifically, the die of the driver chip may be placed in a first package, the die of the switch component may be placed in a second package, and the first package and the second package may be pasted and soldered to the first PCB in a manner like a surface mount technology (surface mount technology, SMT). The driver chip leads to an outer surface of the first package, to form a first pin; and the third end as of the switch component leads to an outer surface of the second package, to form a second pin. The first pin and the second pin are connected through a wire on the first PCB, to implement a connection between the driver chip and the third end as of the switch component. In this way, the driver chip and the switch component are separately packaged, thereby helping reduce complexity of process production.

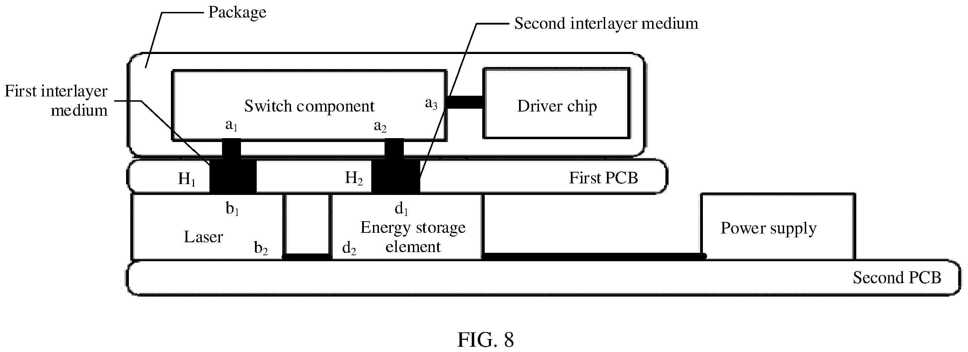

In another example, FIG. 8 shows an example of a schematic diagram of still another circuit structure according to an embodiment of this application. As shown in FIG. 8, in this example, the driver chip and the switch component may be packaged together into one package, that is, the die of the driver chip and the die of the switch component are placed in a same package. The driver chip and the third end as of the switch component are connected inside the package. In addition, the first end a₁ of the switch component leads to the outer surface of the package to form a pin, and then is in contact with the upper surface of the conductive medium that fills the first through hole H1, to implement a connection between the first end a₁ of the switch component and the first end b₁ of the laser. Correspondingly, the second end a₂ of the switch component leads to the outer surface of the package to form a pin, and then is in contact with the upper surface of the conductive medium that fills the second through hole H2, to implement a connection between the second end a₂ of the switch component and the first end d₁ of the energy storage element. In this way, compared with a manner of separately packaging the driver chip and the switch component, a manner of packaging the driver chip and the switch component together into one package can reduce a quantity of packages included in the circuit structure, thereby reducing parasitic elements introduced due to component packaging.

Further, for example, still refer to (B) in FIG. 6. The circuit structure may further include a power supply. A positive electrode of the power supply is separately connected to the second end b₂ of the laser and the second end d₂ of the energy storage element. The negative electrode of the power supply, the second end a₂ of the switch component, and the first end d₁ of the energy storage element are all grounded. For example, grounding may be implemented by connecting the component to a housing of the circuit structure. In this way, the connection relationship between the power supply, the switch component, the laser, and the energy storage element is set, so that the power supply can form a loop with the laser and the switch component, and can further form a loop with the energy storage element, thereby helping the power supply to supply power to the energy storage element and helping the energy storage element to discharge to the laser.

In the foregoing example, there are a plurality of possible layout manners of the power supply. Examples are as follows.

In an example, still refer to (B) in FIG. 6. The power supply may be disposed on the second PCB, and the positive electrode of the power supply is connected to the second end b₂ of the laser and the second end d₂ of the energy storage element through a wire on the second PCB. In this way, the power supply, and the laser and the energy storage element are placed at a same layer, so that the power supply and the laser can be easily connected, the power supply and the energy storage element can be easily connected, and the wire length between the power supply and the laser and the wire length between the power supply and the energy storage element can be reduced by laying out the power supply and the laser more compactly and laying out the power supply and the energy storage element more compactly, thereby reducing parasitic elements introduced due to a wire between the power supply and the laser and a wire between the power supply and the energy storage element.

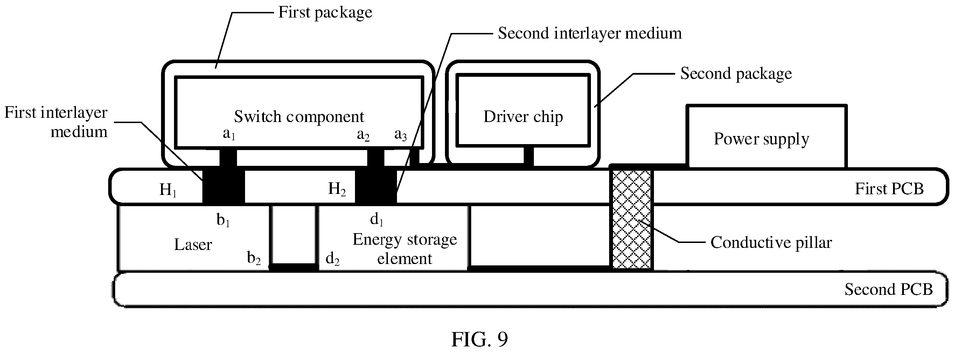

In another example, FIG. 9 shows an example of a schematic diagram of yet another circuit structure according to an embodiment of this application. As shown in FIG. 9, in this example, the power supply is disposed on the first PCB, the circuit structure may further include a conductive pillar, and the conductive pillar is disposed on the second PCB and passes through the first PCB. The positive electrode of the power supply is connected to the second end b₂ of the laser and the second end d₂ of the energy storage element through the wire on the first PCB, the conductive pillar, and the wire on the second PCB. In this way, the power supply, and the laser and the energy storage element that are at different layers are connected through the conductive pillar, so that a winding connection can be reduced, and parasitic elements introduced due to a wire between the power supply and the laser and a wire between the power supply and the energy storage element can be effectively reduced. In addition, the conductive pillar is wider than the conducting wire. Therefore, when the power supply, and the laser and the energy storage element that are at different layers are connected through the conductive pillar, a through-current capability between the power supply, and the laser and the energy storage element can be further improved through the wider conductive pillar, to adapt to a higher through-current requirement.

In Layout solution 1, the components are laid out in a three-dimensional manner, so that a wire length between the components can be reduced. In addition, the die of the laser and the die of the energy storage element are used in the circuit structure, so that a quantity of packages included in the circuit structure can be further reduced. It can be learned that, according to Layout solution 1, parasitic elements introduced due to the wires and the quantity of packages can be reduced, thereby helping improve effective energy conversion efficiency of the circuit structure. In addition, in Layout solution 1, the first PCB and the second PCB are disposed, and the laser and the energy storage element are sandwiched between the first PCB and the second PCB, so that stability of the laser and the energy storage element in the circuit structure can be improved by using a sandwich architecture, and the switch component at the first layer can be further effectively separated from the laser and the energy storage element at the second layer. This helps reduce electrical interference to the switch component, the laser, and the energy storage element in a working state.

### Layout solution 2

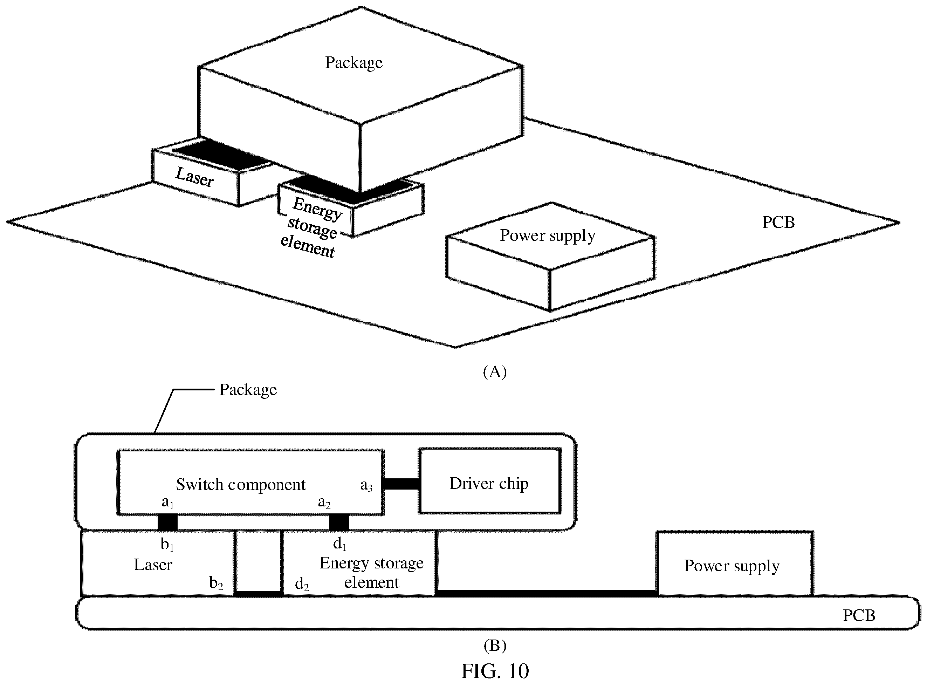

FIG. 10 shows an example of a schematic diagram of still another circuit structure according to an embodiment of this application. (A) in FIG. 10 shows a spatial view of the circuit structure, and (B) in FIG. 10 shows a planar view of the circuit structure. As shown in (A) in FIG. 10 and (B) in FIG. 10, in addition to the switch component and the driver chip that are located at the first layer and the laser and the energy storage element that are located at the second layer, the circuit structure may further include a PCB. The laser and the energy storage element are disposed on the PCB. In addition, because no PCB is disposed between the first layer and the second layer, the die of the switch component and the die of the driver chip may be packaged together into a same package, to carry the switch component and the driver chip that are located at the first layer. A lower surface of the package is disposed together with an upper surface of the laser and an upper surface of the energy storage element. A disposing manner may include but is not limited to gold tin soldering, silver paste bonding, or the like. In addition, the driver chip and the third end as of the switch component is connected inside the package. The first end a₁ of the switch component leads to the lower surface of the package to form a pin, and then is in contact with the first end b₁ of the laser, to implement a connection between the first end a₁ of the switch component and the first end b₁ of the laser. The second end a₂ of the switch component leads to the lower surface of the package to form a pin, and then is in contact with the first end d₁ of the energy storage element, to implement a connection between the second end a₂ of the switch component and the first end d₁ of the energy storage element.

In Layout solution 2, the components are laid out in a three-dimensional manner, so that a wire length between the components can be reduced. In addition, the die of the laser and the die of the energy storage element are used in the circuit structure, so that a quantity of packages included in the circuit structure can be further reduced. It can be learned that, according to Layout solution 2, parasitic elements introduced due to the wires and the quantity of packages can also be reduced, thereby helping improve effective energy conversion efficiency of the circuit structure. In addition, in Layout solution 2, the driver chip and the switch component are packaged together into one package, so that the package can be used as a main body for carrying the switch component and the driver chip, thereby avoiding additional disposing of the first PCB, and helping reduce design costs of the circuit structure. In addition, a quantity of packages included in the circuit structure can be further reduced, and wires on the PCB that are used to connect the switch component and the driver chip are reduced, thereby further reducing parasitic elements introduced due to component packaging and the wires, and further improving effective energy conversion efficiency of the circuit structure.

It should be noted that, for a layout manner of each component in Layout solution 2, refer to Layout solution 1. Details are not described one by one again in this embodiment of this application.

In addition, the circuit structure may have some variants, to obtain a new layout solution. For example, in a possible variant, the circuit structure may further include a resistor element, to flexibly change a luminous intensity of the laser. The resistor element is connected in series to the power supply. For a series connection manner, refer to (C) in FIG. 3 or (D) in FIG. 3. In addition, when the resistor element is laid out, the resistor element and the power supply may be placed at a same layer. For example, both the resistor element and the power supply are disposed on the second PCB in Layout solution 1 or the PCB in Layout solution 2, and are connected through the wire on the PCB. Alternatively, both the resistor element and the power supply are disposed on the first PCB in Layout solution 1, and are connected through the wire on the first PCB. Alternatively, the resistor element and the power supply may be placed at different layers. For example, the power supply is disposed on the first PCB in Layout solution 1; and the resistor element is disposed on the second PCB in Layout solution 1, so that the power supply disposed on the first PCB is connected, sequentially through the wire on the first PCB, the conductive pillar, and the wire on the second PCB, to the resistor element disposed on the second PCB. Alternatively, the power supply is disposed on the PCB in Layout solution 2; and the resistor element, the switch component, and the driver chip are packaged together into the package in Layout solution 2, so that the resistor element in the package is connected, sequentially through the pin of the package, the conductive pillar, and the wire on the PCB, to the power supply disposed on the PCB. There are further many possible layout manners. The possible layout manners are not listed one by one in this embodiment of this application.

In addition, it should be noted that, because a circuit structure may be further affected by a process during manufacturing, there is some process deviation between the circuit structure and the circuit structure described in the foregoing embodiments of this application. However, provided that the deviation falls within a proper process deviation range, the circuit structure falls within the protection scope of embodiments of this application. This is not specifically limited in embodiments of this application.

In the foregoing circuit structure, the switch component is located at one layer, and the laser and the energy storage element are located at another layer. In another design, any two of the elements may be disposed at one layer, and another element is designed at the other layer. In other words, any two components of the switch component, the laser, and the energy storage element are placed in a stacked manner with another component, any one component is located at the first layer, and the other two components are located at the second layer. A first end of the component located at the first layer is connected to a first end of one of the two components located at the second layer through a first interlayer medium. A second end of the component located at the first layer is connected to a second end of the other component located at the second layer through a second interlayer medium. A second end of the one of the two components located at the second layer is connected to a second end of the other component located at the second layer. Other components, such as the resistor, the power supply, and the driver chip, may be disposed at the first layer or the second layer based on a requirement. Alternatively, a third layer may be disposed, and one or more of the other components, such as the resistor, the power supply, or the driver chip, are disposed at the third layer.

For example, it is assumed that a projection of the component located at the first layer in a stacking direction completely overlap projections of the two components located at the second layer. In this case, it is as follows.

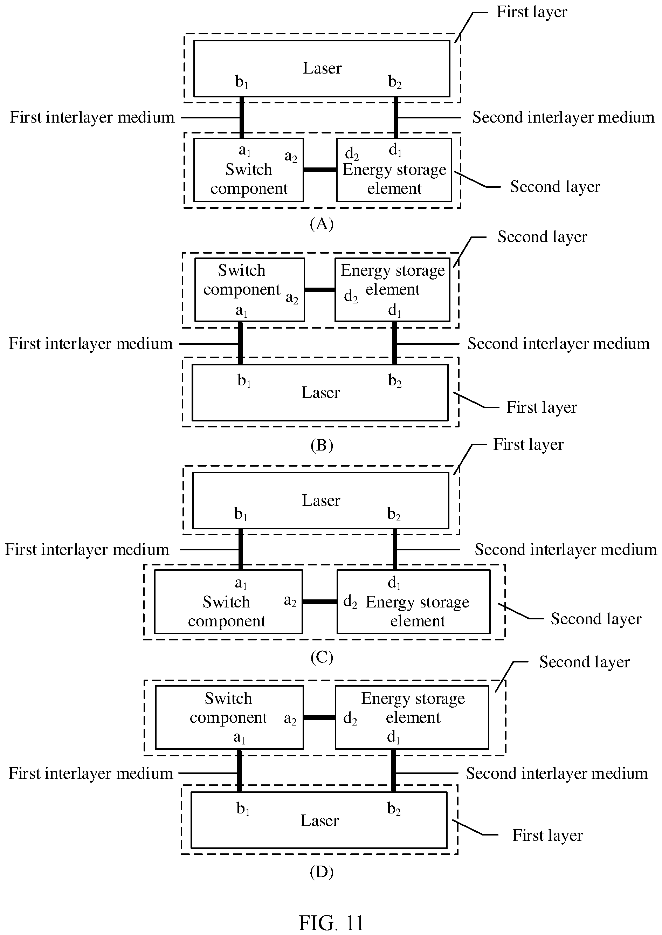

FIG. 11 shows an example of a schematic diagram of yet another circuit structure according to an embodiment of this application. In this example, the laser is located at the first layer, and the switch component and the energy storage element are located at the second layer. The first end b₁ of the laser is connected to the first end a₁ of the switch component, the second end b₂ of the laser is connected to the first end d₁ of the energy storage element, and the second end a₂ of the switch component is connected to the second end d₂ of the energy storage element. The first layer may be located above the second layer, as shown in (A) in FIG. 11 or (C) in FIG. 11. Alternatively, the first layer may be located below the second layer as shown in (B) in FIG. 11 or (D) in FIG. 11. This is not specifically limited in embodiments of this application. In addition, as shown in (A) in FIG. 11 or (B) in FIG. 11, the projections of the switch component and the energy storage element in the stacking direction may entirely overlap the projection of the laser. Alternatively, as shown in (C) in FIG. 11 or (D) in FIG. 11, the projections of the switch component and the energy storage element in the stacking direction may partially overlap the projection of the laser. Alternatively, as shown in (A) in FIG. 11 or (B) in FIG. 11, the projection of the switch component in the stacking direction entirely overlaps the projection of the laser, and as shown in (C) in FIG. 11 or (D) in FIG. 11, the projection of the energy storage element in the stacking direction partially overlaps the projection of the laser. Alternatively, as shown in (A) in FIG. 11 or (B) in FIG. 11, the projection of the energy storage element in the stacking direction entirely overlaps the projection of the laser, and as shown in (C) in FIG. 11 or (D) in FIG. 11, the projection of the switch component in the stacking direction partially overlaps the projection of the laser, or the like. This is also not specifically limited in embodiments of this application.

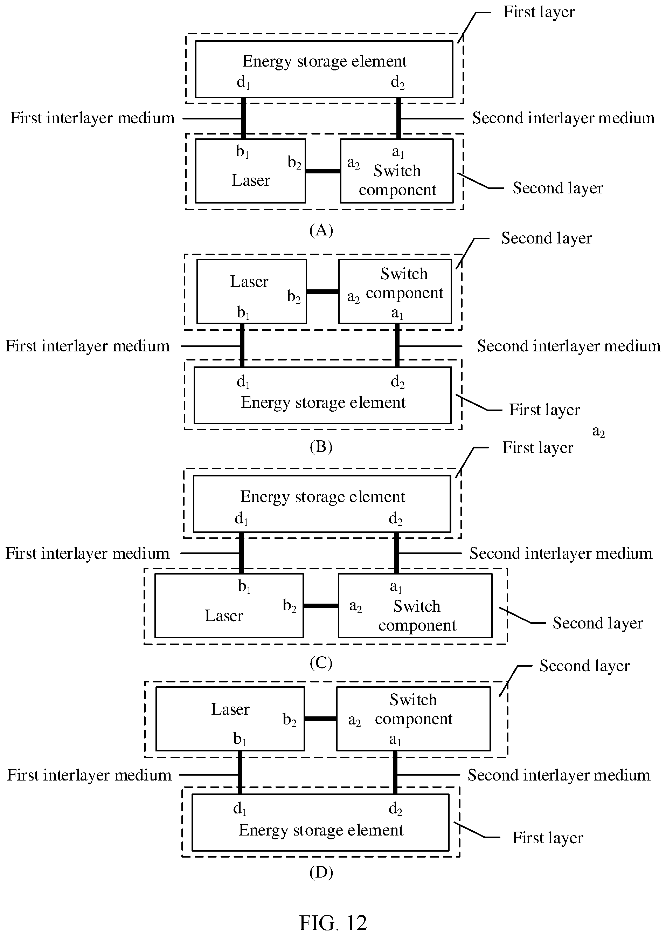

FIG. 12 shows an example of a schematic diagram of yet another circuit structure according to an embodiment of this application. In this example, the energy storage element is located at the first layer, and the laser and the switch component are located at the second layer. The first end d₁ of the energy storage element is connected to the first end b₁ of the laser, the second end d₂ of the energy storage element is connected to the first end a₁ of the switch component, and the second end b₂ of the laser is connected to the second end a₂ of the switch component. The first layer may be located above the second layer, as shown in (A) in FIG. 12 or (C) in FIG. 12. Alternatively, the first layer may be located below the second layer as shown in (B) in FIG. 12 or (D) in FIG. 12. This is not specifically limited in embodiments of this application. In addition, as shown in (A) in FIG. 12 or (B) in FIG. 12, the projections of the laser and the switch component in the stacking direction may entirely overlap the projection of the energy storage element. Alternatively, as shown in (C) in FIG. 12 or (D) in FIG. 12, the projections of the laser and the switch component in the stacking direction may partially overlap the projection of the energy storage element. Alternatively, as shown in (A) in FIG. 12 or (B) in FIG. 12, the projection of the switch component in the stacking direction entirely overlaps the projection of the energy storage element, and as shown in (C) in FIG. 12 or (D) in FIG. 12, the projection of the switch component in the stacking direction partially overlaps the projection of the energy storage element. Alternatively, as shown in (A) in FIG. 12 or (B) in FIG. 12, the projection of the switch component in the stacking direction entirely overlaps the projection of the energy storage element, and as shown in (C) in FIG. 12 or (D) in FIG. 12, the projection of the laser in the stacking direction partially overlaps the projection of the energy storage element, or the like. This is also not specifically limited in embodiments of this application.

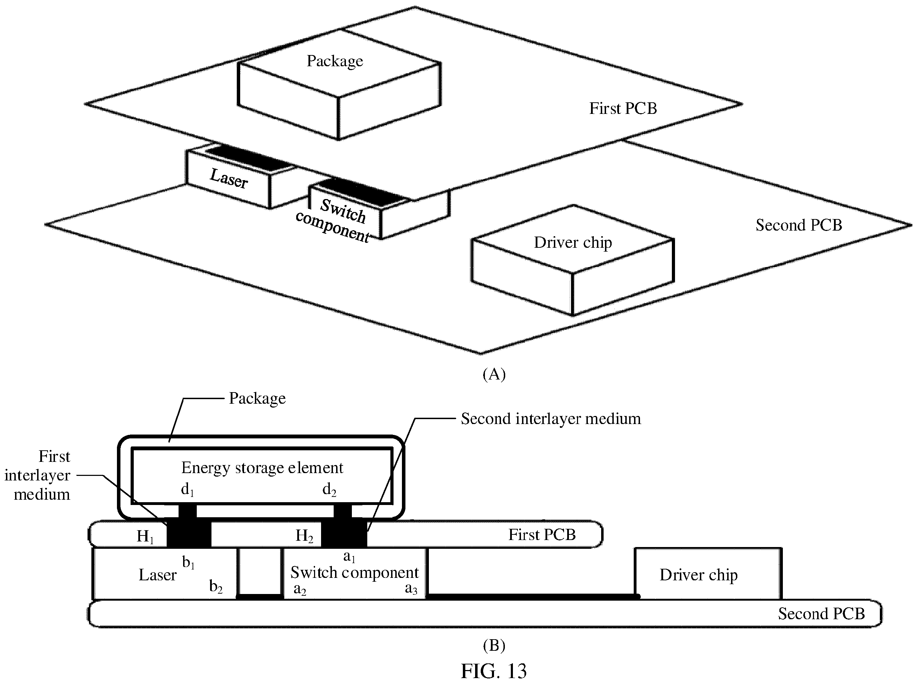

It should be noted that, in any one of the foregoing examples in FIG. 11 or FIG. 12, for specific layout manners of the components located at the first layer and the components located at the second layer, refer to any one of the embodiments in FIG. 6, FIG. 8, FIG. 9, or FIG. 10. For example, when the circuit structure shown in (C) in FIG. 12 is laid out and designed in the manner shown in FIG. 6, for a specific circuit structure, refer to FIG. 13. In this example, the energy storage element is disposed on the first PCB, and the laser and the switch component are disposed on the second PCB, and are sandwiched between the first PCB and the second PCB, so that the entire circuit structure is of a sandwich architecture. In addition, in this example, the driver chip may be further disposed on the second PCB. The driver chip and the switch component are disposed at a same layer, so that the driver chip and the switch component can be easily connected through the wire on the second PCB, thereby reducing complexity of a circuit layout. It should be understood that for another example, layout design may also be performed with reference to the embodiments in FIG. 6, FIG. 8, FIG. 9, or FIG. 10. Details are not described one by one again in this embodiment of this application.

It should be understood that the foregoing circuit structure may be applied to a transmit module of a lidar, or may be applied to a receiving module of the lidar or a control circuit of the lidar, or may be applied to an apparatus, component, or chip other than the lidar. For example, the circuit structure is applied to an intelligent terminal, other than the lidar, that has a high effective energy conversion efficiency requirement, or disposed in a component of another intelligent terminal, where the component includes but is not limited to another sensor like a controller, a chip, or a camera, and another component. Alternatively, the circuit structure may be further applied to an imaging system other than the foregoing autonomous driving system or assisted driving system, for example, a building three-dimensional modeling system, a terrain surveying and mapping system, or a rendezvous and docking system. In addition, with evolution of a system architecture and emergence of a new scenario, the circuit structure provided in embodiments of this application is applicable to a similar technical problem. This is not specifically limited in embodiments of this application.

For example, an embodiment of this application provides a circuit structure, including a first component, a second component, and a third component. Any two components are placed in a stacked manner with another component, any one component is located at a first layer, and the other two components are located at a second layer. A first end of the component located at the first layer is connected to a first end of one of the two components located at the second layer through a first interlayer medium. A second end of the component located at the first layer is connected to a first end of the other component located at the second layer through a second interlayer medium. A second end of the one of the two components located at the second layer is connected to a second end of the other component located at the second layer. Other components may be disposed at the first layer or the second layer based on a requirement. Alternatively, a third layer may be disposed, and some or all of other components are disposed at the third layer.

According to the circuit structure provided in this embodiment of this application, an embodiment of this application further provides a transmit module. The transmit module may include a power supply, a driver chip, and the circuit structure described in the foregoing content. The power supply is configured to supply power to the circuit structure, the driver chip is configured to send a drive signal to the circuit structure, and the circuit structure is configured to emit detection laser light based on the drive signal.

According to the transmit module provided in this embodiment of this application, an embodiment of this application further provides a detection apparatus. The detection apparatus may include a control circuit and the transmit module described in the foregoing content. The control circuit is configured to send a control signal to the transmit module, and the transmit module is configured to emit detection laser light based on the control signal.

In a possible design, the detection apparatus may further include a receiving module. The receiving module is configured to: receive an echo signal returned after the detection laser light scans a target object, and convert the echo signal into an electrical signal. The control circuit is further configured to process the electrical signal, to obtain point cloud data.

In a possible design, the detection apparatus may further include a scanning module. The scanning module is configured to: traverse and scan the target object by using detection laser light.

In a possible design, the detection apparatus may be a lidar, or another apparatus that can emit detection laser light. For example, examples of some detection apparatuses include but are not limited to: a vehicle-mounted lidar, a laser sensor of a home vacuum cleaning robot, a dock laser light detection module, a laser light printer, and the like.

According to the detection apparatus provided in this embodiment of this application, an embodiment of this application further provides a terminal device, including the detection apparatus described in the foregoing content.

For example, examples of some terminal devices include but are not limited to: a smart home device (like a television, a vacuum cleaning robot, a smart desk lamp, a sound system, an intelligent lighting system, an electrical control system, home background music, a home theater system, an intercom system, or video surveillance), a smart transportation device (like a vehicle, a ship, an uncrewed aerial vehicle, a train, a van, or a truck), a smart manufacturing device (like a robot, an industrial device, smart logistics, or a smart factory), and an intelligent terminal (a mobile phone, a computer, a tablet, a palmtop computer, a desktop computer, a headset, a speaker, a wearable device, a vehicle-mounted device, a virtual reality device, an augmented reality device, or the like)

According to the circuit structure provided in embodiments of this application, an embodiment of this application further provides a packaging method. The method includes: providing a switch component, a laser, an energy storage element, a first interlayer medium, and a second interlayer medium; placing the switch component at a first layer, and placing the laser and the energy storage element at a second layer; placing the laser, the energy storage element, and the switch component in a stacked manner; disposing the first interlayer medium and the second interlayer medium between the first layer and the second layer; connecting one end of the first interlayer medium to a first end of the switch component, and connecting the other end of the first interlayer medium to a first end of the laser; connecting one end of the second interlayer medium to a second end of the switch component, and connecting the other end of the second interlayer medium to a first end of the energy storage element; and connecting a second end of the laser to a second end of the energy storage element.

In a possible design, the placing the switch component at a first layer, and placing the laser at a second layer includes: placing the switch component in a first area of the first layer, and placing the laser in a second area of the second layer, where a first overlap exists between projections of the first area and the second area in a stacked placement direction. In this case, the disposing the first interlayer medium between the first layer and the second layer includes: disposing the first interlayer medium in an area corresponding to the first overlap between the first layer and the second layer.

In a possible design, the placing the switch component at a first layer, and placing the energy storage element at a second layer includes: placing the switch component in the first area of the first layer, and placing the energy storage element in a third area of the second layer, where a second overlap exists between projections of the third area and the first area in the stacked placement direction. In this case, the disposing the second interlayer medium between the first layer and the second layer includes: disposing the second interlayer medium in an area corresponding to the second overlap between the first layer and the second layer.

In a possible design, a first PCB may be further provided, and the first PCB is placed between the first layer and the second layer.

In a possible design, a first through hole and a second through hole may be further provided on the first PCB. The first through hole is filled with the first interlayer medium, and the second through hole is filled with the second interlayer medium.

In a possible design, a second PCB may be further provided. The laser and the energy storage element are disposed on the second PCB, and a wire is disposed on the second PCB. One end of the wire is connected to the second end of the laser, and the other end of the wire is connected to the second end of the energy storage element.

In a possible design, a driver chip may be further provided. The driver chip is connected to a third end of the switch component.

In a possible design, the driver chip may be further placed at the first layer.

In a possible design, the driver chip and the switch component may be further placed in a same package or different packages in a die form.

In a possible design, a power supply may be further provided. A positive electrode of the power supply is connected to the second end of the laser and the second end of the energy storage element, and a negative electrode of the power supply is grounded.

In a possible design, the power supply may be further disposed on the second PCB, and a wire is disposed on the second PCB. One end of the wire is connected to the positive electrode of the power supply, and the other end of the wire is connected to the second end of the laser and the second end of the energy storage element.

In a possible design, a conductive pillar may be further provided. The power supply is disposed on the first PCB, the conductive pillar is disposed on the second PCB, and the conductive pillar passes through the first PCB. A first wire is disposed on the first PCB, and a second wire is disposed on the second PCB. One end of the first wire is connected to the power supply, and the other end of the first wire is connected to one end of the conductive pillar. The other end of the conductive pillar is connected to one end of the second wire, and the other end of the second wire is connected to the second end of the laser and the second end of the energy storage element.

In a possible design, a resistor element may be further provided. A first end of the resistor element is connected to the positive electrode of the power supply, and a second end of the resistor element is connected to the second end of the laser and the second end of the energy storage element. Alternatively, a first end of the resistor element is connected to the negative electrode of the power supply, and a second end of the resistor element is grounded after being connected to the second end of the switch component and the first end of the energy storage element.

In a possible design, the providing a switch component includes: providing a die of the laser.

In a possible design, the providing an energy storage element includes: providing a die of the energy storage element.

According to the packaging method provided in this embodiment of this application, an embodiment of this application further provides a computer-readable storage medium. The computer-readable storage medium stores a computer program. When the computer program is run, the packaging method described in the foregoing content is performed.

According to the packaging method provided in this embodiment of this application, an embodiment of this application further provides a computer program product. When the computer program product runs on a processor, the packaging method described in the foregoing content is implemented.

The foregoing descriptions are merely specific implementations of this application, but the protection scope of this application is not limited thereto. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit structure, comprising:
a switch component; and
a laser and an energy storage element, wherein
the switch component, the laser, and the energy storage element are placed in a stacked manner, the switch component is located at a first layer, and the laser and the energy storage element are located at a second layer; and
a first end of the switch component is connected to a first end of the laser through a first interlayer medium, a second end of the switch component is connected to a first end of the energy storage element through a second interlayer medium, and a second end of the laser is connected to a second end of the energy storage element.

2. The circuit structure according to claim 1, wherein
a first overlap exists between projections of the switch component and the laser in a direction in which the switch component and the laser are placed in the stacked manner, and the first interlayer medium is disposed in an area corresponding to the first overlap between the first layer and the second layer; and/or
a second overlap exists between projections of the switch component and the energy storage element in a direction in which the switch component and the energy storage element are placed in the stacked manner, and the second interlayer medium is disposed in an area corresponding to the second overlap between the first layer and the second layer.

3. The circuit structure according to claim 1 or 2, further comprising:
a first printed circuit board PCB, wherein
the first PCB is located between the first layer and the second layer.

4. The circuit structure according to claim 3, wherein the first interlayer medium and the second interlayer medium pass through the first PCB.

5. The circuit structure according to any one of claims 1 to 4, further comprising:
a second PCB, wherein
the laser and the energy storage element are disposed on the second PCB, and the second end of the laser is connected to the second end of the energy storage element through a wire on the second PCB.

6. The circuit structure according to claim 5, further comprising:
a driver chip, wherein
the driver chip is connected to a third end of the switch component.

7. The circuit structure according to claim 6, wherein the driver chip is located at the first layer.

8. The circuit structure according to claim 7, wherein the driver chip and the switch component are placed in a same package or different packages in a die form.

9. The circuit structure according to any one of claims 5 to 8, further comprising:
a power supply, wherein
a positive electrode of the power supply is connected to the second end of the laser and the second end of the energy storage element, and a negative electrode of the power supply is grounded.

10. The circuit structure according to claim 9, wherein
the power supply is disposed on the second PCB, and the positive electrode of the power supply is connected to the second end of the laser and the second end of the energy storage element through the wire on the second PCB.

11. The circuit structure according to claim 9, further comprising:
a conductive pillar, wherein
the conductive pillar is disposed on the second PCB and passes through the first PCB; and
the power supply is disposed on the first PCB, and the positive electrode of the power supply is connected to the second end of the laser and the second end of the energy storage element through a wire on the first PCB, the conductive pillar, and the wire on the second PCB.

12. The circuit structure according to any one of claims 9 to 11, further comprising:
a resistor element, wherein
a first end of the resistor element is connected to the positive electrode of the power supply, and a second end of the resistor element is connected to the second end of the laser and the second end of the energy storage element; or
a first end of the resistor element is connected to the negative electrode of the power supply, and a second end of the resistor element is grounded after being connected to the second end of the switch component and the first end of the energy storage element.

13. The circuit structure according to any one of claims 1 to 12, wherein
the laser is a die; and/or
the energy storage element is a die.

14. A transmit module, comprising a power supply, a driver chip, and the circuit structure according to any one of claims 1 to 13, wherein
the power supply is configured to supply power to the circuit structure;
the driver chip is configured to send a drive signal to the circuit structure; and
the circuit structure is configured to emit detection laser light based on the drive signal.

15. A detection apparatus, comprising a control circuit and the transmit module according to claim 14, wherein
the control circuit is configured to send a control signal to the transmit module; and
the transmit module is configured to emit detection laser light based on the control signal.

16. The detection apparatus according to claim 15, further comprising a receiving module, wherein
the receiving module is configured to: receive an echo signal returned after the detection laser light scans a target object, and convert the echo signal into an electrical signal; and
the control circuit is further configured to process the electrical signal, to obtain point cloud data.

17. A terminal device, comprising the detection apparatus according to claim 15 or 16.
